Europäisches Patentamt

European Patent Office

Office européen des brevets

(19)

(11) **EP 0 843 897 B1**

(12) **EUROPÄISCHE PATENTSCHRIFT**

(45) Veröffentlichungstag und Bekanntmachung des Hinweises auf die Patenterteilung:
**30.08.2000 Patentblatt 2000/35**

(21) Anmeldenummer: **96917357.4**

(22) Anmeldetag: **18.06.1996**

(51) Int Cl.⁷: **H01L 27/02**, H01L 29/41

(86) Internationale Anmeldenummer:
**PCT/DE96/01073**

(87) Internationale Veröffentlichungsnummer:
**WO 97/04486 (06.02.1997 Gazette 1997/07)**

(54) **MONOLITHISCH INTEGRIERTE PLANARE HALBLEITERANORDNUNG MIT TEMPERATURKOMPENSATION**

MONOLITHICALLY INTEGRATED PLANAR SEMI-CONDUCTOR ARRANGEMENT WITH TEMPERATURE COMPENSATION

DISPOSITIF SEMI-CONDUCTEUR PLANAR INTEGRE MONOLITHIQUE A COMPENSATION DE TEMPERATURE

(84) Benannte Vertragsstaaten:
**DE FR GB**

(30) Priorität: **22.07.1995 DE 19526902**

(43) Veröffentlichungstag der Anmeldung:
**27.05.1998 Patentblatt 1998/22**

(73) Patentinhaber: **ROBERT BOSCH GMBH**
**70442 Stuttgart (DE)**

(72) Erfinder:
• **MICHEL, Hartmut**
  **D-72762 Reutlingen (DE)**
• **PLUNTKE, Christian**
  **D-72379 Hechingen (DE)**
• **GOERLACH, Alfred**
  **D-72127 Kusterdingen (DE)**

(56) Entgegenhaltungen:
**EP-A- 0 179 099          WO-A-85/05223**
**US-A- 3 567 965          US-A- 4 749 889**

• **PATENT ABSTRACTS OF JAPAN vol. 012, no. 291 (E-644), 9.August 1988 & JP,A,63 067766 (NEC CORP), 26.März 1988,**

**Beschreibung**

Stand der Technik

Die Erfindung geht aus von einer Halbleiteranordnung nach der Gattung des unabhängigen Anspruchs.

Aus der europäischen Patentschrift 99 897 bzw. der entsprechenden WO-A-83/02528 ist bereits eine Halbleiteranordnung bekannt, bei der in ein Substrat mit einer schwachen Dotierung des ersten Leitfähigkeitstyps eine Zone eines zweiten Leitfähigkeitstyps eingebracht ist, die mit dem Substrat einen PN-Übergang bildet. Um die Durchbruchspannung zwischen der eingebrachten Zone und dem Substrat zu beeinflussen, ist auf der Oberfläche eine Deckelektrode angebracht, die vom Substrat durch eine dünne Oxidschicht getrennt ist. Durch Einstellen des Potentials dieser Deckelektrode mittels eines Spannungsteilers wird die Durchbruchspannung des PN-Überganges eingestellt.

Aus der europäischen Patentschrift 179 099 bzw. der entsprechenden WO-A-85/05223 ist ebenfalls eine derartige Halbleiteranordnung bekannt, bei der der Spannungsteiler durch integrierte Widerstände gebildet wird, die unterschiedlich stark dotiert sind. Es ergibt sich dadurch eine gewisse Kompensation der Temperaturabhängigkeit der Durchbruchspannung. Durch die unterschiedlich dotierten Teilerwiderstände werden dabei zusätzliche Prozeßschritte benötigt. Weiterhin benötigen derartige Widerstände vergleichsweise viel Chipfläche.

Vorteile der Erfindung

Die erfindungsgemäße Halbleiteranordnung mit den Merkmalen des unabhängigen Anspruchs hat demgegenüber den Vorteil, daß die Temperaturabhängigkeit der Durchbruchspannung besonders gut kompensiert wird. Dabei werden keinerlei zusätzliche Prozeßschritte zur Herstellung des Spannungsteilers benötigt, und der Bedarf an Chipfläche für den integrierten Spannungsteiler ist gering.

Durch die in den abhängigen Ansprüchen aufgeführten Maßnahmen sind vorteilhafte Weiterbildungen und Verbesserungen der Halbleiteranordnung nach dem unabhängigen Anspruch möglich. Besonders einfach werden die Elemente mit positivem Temperaturkoeffizienten durch Widerstände, Zenerdioden bzw. Kombinationen von beiden Elementen gebildet. Für das Bauelement mit negativem Temperaturkoeffizienten läßt sich in einfacher Weise ein Transistor nutzen, dessen Emitterbasisspannung einen negativen Temperaturgang aufweist. Dieser Transistor wird zweckmäßigerweise in das Substrat integriert, wobei dies besonders platzsparend erfolgt, wenn die eingebrachte Zone als Kollektor des Hilfstransistors mitgenutzt wird. Für eine besonders exakt definierte Durchbruchspannung ist die Verwendung einer stark dotierten Zone vom Leitfähigkeitstyp des Substrats im Bereich der Raumladungszone vorteilhaft.

Zeichnungen

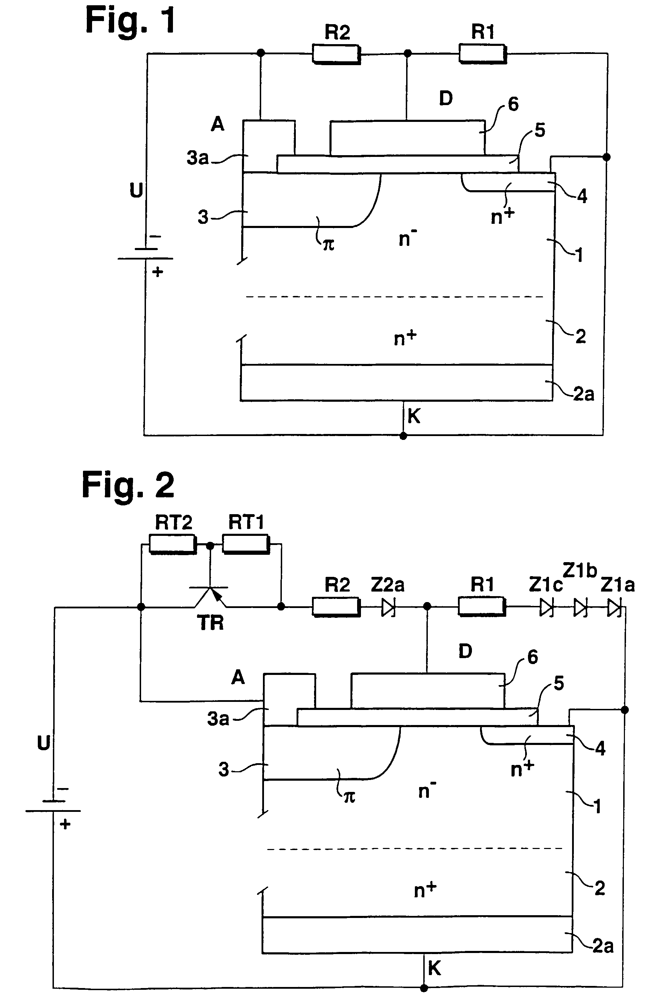

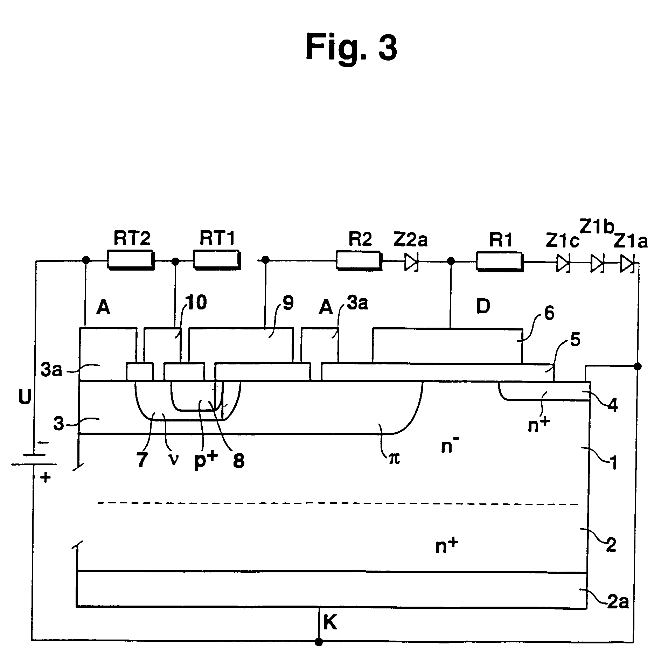

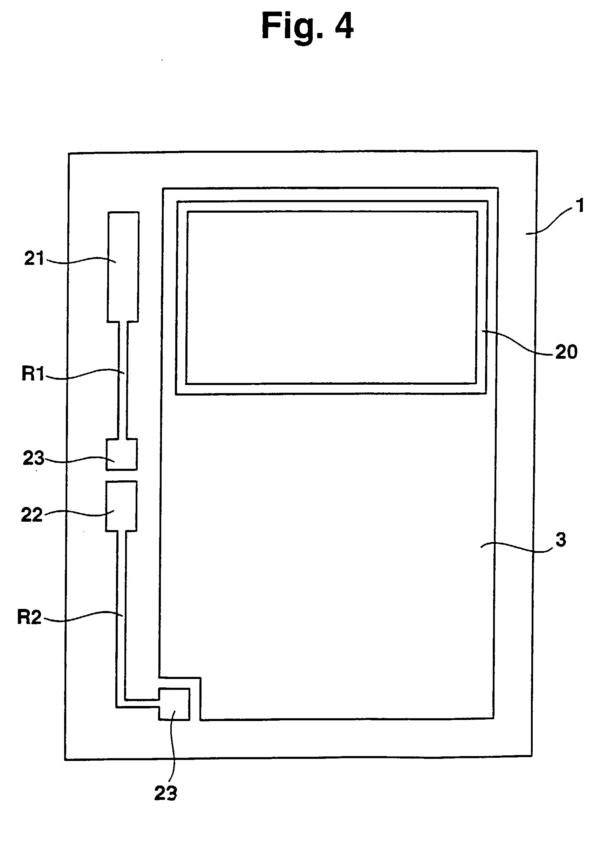

In der Figur 1 wird ein Querschnitt durch eine herkömmliche Halbleiteranordnung, in der Figur 2 ein Querschnitt durch eine erfindungsgemäße Halbleiteranordnung mit symbolischer Darstellung des Spannungsteilers, in der Figur 3 die Halbleiteranordnung nach Figur 2 mit eingebrachten Diffusionszonen für den Transistor, und in den Figuren 4, 5 und 6 wird eine Aufsicht auf ein Ausführungsbeispiel der Erfindung gezeigt.

Beschreibung der Ausführungsbeispiele

In der Figur 1 wird eine Halbleiteranordnung nach der EP 99 897 gezeigt. Die Halbleiteranordnung weist ein Substrat mit einer oberen schwach n-dotierten Schicht 1 und einer unteren stark n-dotierten Schicht 2 auf. Die untere Schicht ist durch eine rückseitige Metallschicht 2a kontaktiert. In die Oberseite des Substrats sind in die $\pi$-Schicht 1 eine schwache P-Diffusion 3 und eine starke N-Diffusion 4 eingebracht, die im folgenden als $\pi$-Diffusion 3 und N+ Diffusion 4 bezeichnet werden. Auf der Oberseite des Substrats ist ein Deckoxid 5 mit einer darauf angeordneten Deckelektrode 6 vorgesehen. Die Deckelektrode 6 und das Deckoxid 5 überdecken den Bereich, der n-Schicht 1 die zwischen der $\pi$-Diffusion 3 und der N+ Diffusion 4 angeordnet ist. Weiterhin ist eine Anschlußmetallisierung 3a zur Kontaktierung der $\pi$-Zone 3 vorgesehen. Um einen ohmschen Kontakt zu gewährleisten, ist unterhalb der Zone 3a noch eine starke P-Dotierung angeordnet, die jedoch aus Übersichtlichkeitsgründen hier nicht gezeigt wird. Die Metallisierung 3a ist mit dem negativen und die Metallisierung 2a mit dem positiven Pol einer Betriebsspannung U verbunden. Die Deckelektrode 6 ist mit dem Abgriff eines Spannungsteilers R1, R2 verbunden, der zwischen dem positiven und negativen Pol der Betriebsspannung angeordnet ist. Das Potential der Deckelektrode wird durch diesen Spannungsteiler auf einen Wert zwischen der positiven und negativen Betriebsspannung angeordnet. Die N+ Dotierung 4 weist ebenfalls das Potential der Rückseitenmetallisierung 2a auf.

Die Funktion dieser Anordnung ist bereits in der Ep 99 897 ausführlich beschrieben. Zweck der gezeigten Vorrichtung ist die kontrollierte Einstellung der Durchbruchspannung zwischen der $\pi$-Zone 3 und dem Substrat. Unter Durchbruchspannung ist dabei die maximal mögliche Sperrspannung zu verstehen, die zwischen der p-dotierten Zone 3 und dem n-dotierten Substrat angelegt werden kann. Durch die unmittelbare Nähe von π-Dotierung 3 und N+-Dotierung 4 erfolgt der Durchbruch zwischen diesen beiden Zonen. Durch das Potential an der Deckelektrode 6 läßt sich die Durchbruchspannung beeinflussen, insbesondere kann durch die richtige Auslegung des Verhältnisses der Widerstände R1 und R2 die Durchbruchspannung optimiert werden. Neben einer möglichst hohen Durchbruchspannung ist es dabei wünschenswert, den absoluten Wert der Durchbruchspannung möglichst genau kontrollieren zu können. Dabei soll insbesondere der Wert der Durchbruchspannung von der Betriebstemperatur des Halbleiterbauelements unabhängig sein.

In der Figur 2 wird ein erstes Ausführungsbeispiel des erfindungsgemäßen Halbleiterbauelements gezeigt. Gleichwirkende Elemente sind wieder mit dem gleichen Bezugszeichen wie in der Figur 1 bezeichnet. Im Unterschied zu dem Stand der Technik nach der Figur 1 weist das Ausführungsbeispiel nach der Figur 2 einen verbesserten Spannungsteiler auf. Der negative Pol der Versorgungsspannung und somit auch die Metallisierung 3a der π-Dotierung 3 ist mit dem Kollektor eines PNP-Hilfstransistors TR verbunden. Der Emitter des Hilfstransistors TR ist mit einem Widerstand R2 verbunden. Die Emitter-Basis-Strecke des Hilfstransistors TR wird von einem Widerstand RT1, und die Basis-Kollektor-Strecke des Hilfstransistors TR wird von einem Widerstand RT2 überbrückt. Der Widerstand R2 ist mit der Anode einer Zenerdiode Z2a verbunden. Die Katode der Zenerdiode Z2a ist mit dem Spannungsabgriff für die Deckelektrode 6 und einem Anschluß eines Widerstands R1 verbunden. Der andere Anschluß des Widerstands R1 ist mit der Anode einer Zenerdiode Z1c verbunden. Die Katode der Zenerdiode Z1c ist mit der Anode einer weiteren Zenerdiode Z1b verbunden. Die Katode der Zenerdiode Z1b ist mit der Anode einer Zenerdiode Z1a verbunden. Die Katode der Zenerdiode Z1a ist mit der starken Endotierung 4, der Rückseitenmetallisierung 2a und dem positiven Betriebsspannungsanschluß verbunden.

Die Durchbruchspannung U hängt nach folgender Formel von den Spannungsabfällen an den einzelnen Bauelementen des Spannungsteilers ab:

$$U = U1 \times \{UR1 + UR2 + UZ(n + m) + UCE\}/\{UR1 + mUZ\}.$$

Dabei sind UR1 und UR2 die Spannungsabfälle an den Widerständen R1, R2, UZ der Spannungsabfall an jeder Zenerdiode, m + n die Anzahlen der jeweiligen Zenerdioden, wobei hier n = 1 und m = 3 ist und U1 steht für die Durchbruchsspannung, die man erhält, wenn der Spannungsabfall zwischen Anode A und Deckelektrode D null ist. Der Spannungsabfall UCE an der Basisemitterstrecke des Hilfstransistors TR hängt nach folgender Formel von der Basisemitterspannung UBE des Transistors TR ab:

$$UCE = UBE \times (1 + RT2/RT1).$$

Die Zenerdioden Z1 und Z2 arbeiten nach dem Avalanche-Effekt und weisen daher einen positiven Temperaturkoeffizienten auf. Weiterhin weisen die Widerstände R1, R2, RT1 und RT2 einen positiven Temperaturkoeffizienten auf, d. h. ihr Widerstand erhöht sich mit steigender Temperatur. Die Spannung U1 weist ebenfalls einen positiven Temperaturkoeffizienten auf. Der Spannungsabfall am Hilfstransistor TR wird durch den Spannungsabfall UBE an der Basisemitterstrecke bestimmt. Dieser Spannungsabfall weist einen negativen Temperaturkoeffizienten auf. Da der Spannungsteiler somit Elemente mit positiven und mit negativen Temperaturkoeffizienten aufweist, kann die Temperaturabhängigkeit am Abgriff des Spannungsteilers weitgehend kompensiert werden. Durch eine geeignete Wahl der Widerstandswerte, der Spannungen der Zenerdioden und des Hilfstransistors TR läßt sich so erreichen, daß die Durchbruchspannung des Bauelements weitgehend unabhängig von der Temperatur wird. Weiterhin können alle verwendeten Bauelemente besonders platzsparend mit den üblichen Techniken in das Halbleitersubstrat integriert werden. Es wird so besonders einfach ein Halbleiterelement mit definierter Durchbruchspannung geschaffen.

In der Figur 3 wird das Halbleiterbauelement nach der Figur 2 dahingehend konkreter dargestellt, daß der in der Figur 2 nur als Schaltsymbol gezeichnete Hilfstransistor in der Figur 3 als Diffusionszonen mit entsprechenden Anschlußkontaktierungen dargestellt wird. Für den Hilfstransistor TR ist in die π-Dotierungszone 3 eine schwache N-Dotierungszone 7 und eine P+ Dotierungszone 8 eingebracht. Die P+ Dotierungszone 8 bildet den Emitter, die schwache N-Dotierungszone 7 die Basis und die π-Dotierungszone 3 den Kollektor des Hilfstransistors TR. Die Emittermetallisierung 9 ist zwischen dem Widerstand RT1 und R2 und die Basismetallisierung 10 des Hilfstransistors TR ist zwischen dem Widerstand RT2 und RT1 angeschlossen.

Zu bemerken ist hier, daß die Integration des Hilfstransistors TR in die π-Dotierung 3 nur aufgrund der anliegenden Potentiale des Spannungsteilers möglich ist. Beim Anliegen einer Sperrspannung zwischen der π-Metallisierung und den N-Dotierungen 1, 2, 4 des Substrats kommt es zur Ausbildung einer Sperrzone, die in die π-Dotierung 3 bzw. in die N- Dotierung 1 hineinreicht. Sofern die Sperrzone die N-Dotierung 7 erreicht, wird die Funktion des Hilfstransistors TR gestört (Punch-through). Da jedoch durch den Spannungsteiler RT2, RT1 entsprechende Spannungen an der N-Zone 7 bzw. der π-Zone 3 anliegen, wird diese Funktionsstörung des Hilfstransistors TR vermieden. Es ist daher ohne weitere Schutzmaßnahmen möglich, den Hilfstransistor TR in der π-Zone 3 zu integrieren.

Das in den Figuren 2 und 3 beschriebene Halbleiterelement stellt eine Diode zwischen der π-Dotierung 3 und dem n-dotierten Substrat dar. In die π-Zone 3 können jedoch auch andere Diffusionszonen eingebracht werden, um beispielsweise einen Transistor zu bilden. Weiterhin können auch im Substrat andere Zonen vorgesehen werden, beispielsweise um einen Darlingtontransistor auszubilden. In den folgenden Figuren 4, 5 und 6 wird in der Aufsicht ein integrierter Darlingtontransistor gezeigt, wobei im Substrat zusätzlich noch alle Elemente des aus den Figuren 2 und 3 bekannten Spannungsteilers integriert sind.

In der Figur 4 wird eine Aufsicht auf die obere schwach n-dotierte Schicht 1 eines Halbleitersubstrats gezeigt. In diese schwach n-dotierte Schicht 1 ist eine schwach dotierte Schicht (π-Schicht) eindiffundiert. Der größte Bereich wird von der π-Schicht 3, wie sie bereits aus den Figuren 2 und 3 bekannt ist, eingenommen. Die Schicht 3 bildet hier die Basis eines Darlingtontransistors. Durch die innerhalb der π-Schicht 3 angeordnete schwach p-dotierte Zone 20 wird die Basis des dazugehörigen Darlingtontreibertransistors gebildet. Weiterhin ist eine P-Wanne 21 für die Zenerdioden Z1a bis Z1c vorgesehen. Eine weitere Wanne 22 ist für die Zenerdiode Z2a vorgesehen. Durch die länglichen eindiffundierten P-Streifen werden die Widerstände R1 und R2 gebildet. Diese Widerstände R1 und R2 münden jeweils in Anschlußbereiche 23, in denen ein Anschluß zur Metallisierung vorgesehen wird.

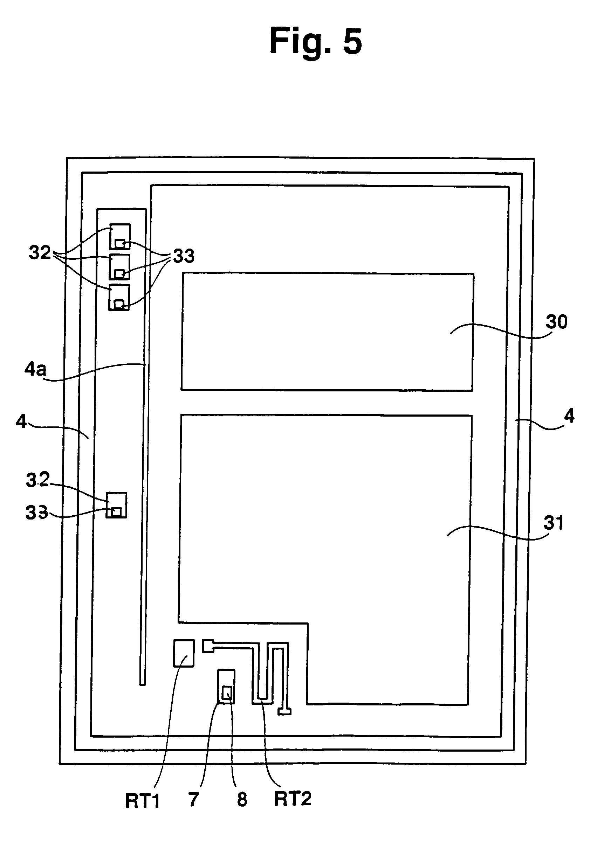

In der Figur 5 werden in der Aufsicht einige schwache n-Dotierungen gezeigt, die jeweils in P-Zonen eingebracht sind, die in der Figur 4 gezeigt wurden. Die schwach dotierten Zonen 30 und 31 bilden den Emitter des Darlingtontreibertransistors und des Darlingtontransistors. Weitere schwach dotierte Zonen sind für die Widerstände RT1 und RT2 des Hilfstransistors und für die Basis 7 des Hilfstransistors vorgesehen. Die schwachen Endotierungszonen 32 bilden die Kathoden der Zenerdioden Z1 und Z2. Weiterhin ist in der Aufsicht die starke n-Dotierung 4 zu erkennen. Die starke n-Dotierung 4, die in etwa rahmenförmig ausgebildet ist, geht in eine streifenförmige starke n-Dotierung 4a über, durch die die Substratbereiche, in denen die Darlingtontransistoren angeordnet sind, von den Bereichen getrennt werden, in denen die Dioden und Widerstände angeordnet sind. Weiterhin werden in der Figur 5 noch stark p-dotierte Bereiche gezeigt, die jeweils in die schwach n-dotierten Bereiche eingebettet sind. Die Bereiche 33 bilden die Anoden der Zenerdioden und sind in die schwach n-dotierten Katoden 32 eingebettet. Die starke p-Dotierung 8 bildet den Emitter des Hilfstransistors TR und ist in die schwach dotierte Basiszone 7 eingebettet.

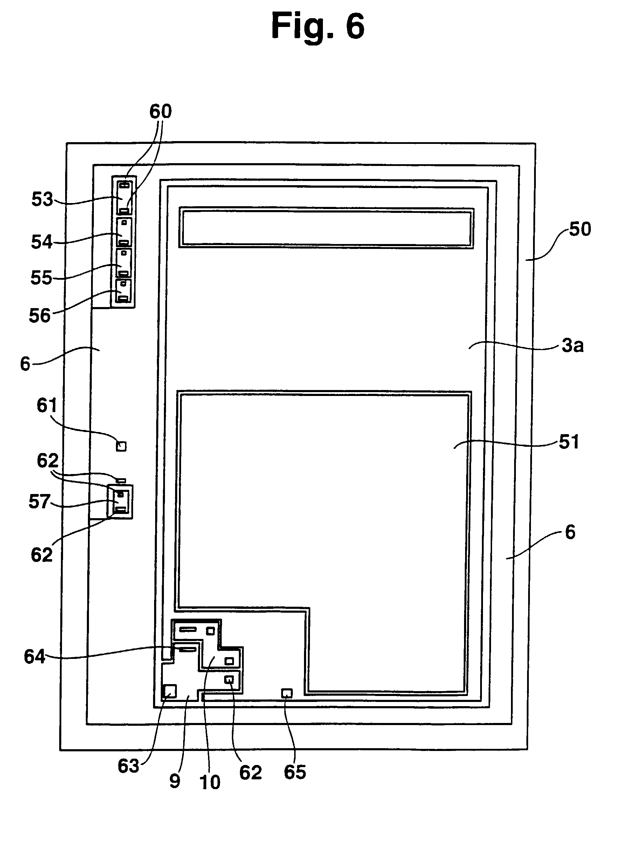

In der Figur 6 wird eine Aufsicht auf das Halbleiterelement gezeigt, wobei die Metallisierung und Kontaktierungen gezeigt sind. Bei den Kontaktierungen handelt es sich um Öffnungen in Passivierungsschichten, die üblicherweise die Oberfläche von integrierten Halbleiten bedecken, in denen die Metallschicht unmittelbar mit darunterliegenden Siliziumschichten verbunden ist. Wenn dabei die Metallschicht auf einem schwach dotierten Bereich aufliegen würde, würde durch den Metall-Halbleiter Übergang eine Schottky-Diode gebildet. Derartige Dioden werden vermieden indem in den Kontaktierungen starke Aufdotierungen für einen ohmschen Kontakt vorgesehen sind.

Durch einen Vergleich der Figuren 6 und 4 erkennt man, daß die Metallisierung 50 den Basisanschluß des Darlingtontreibertransistors darstellt. Durch einen Vergleich der Figuren 6 und 5 erkennt man, daß durch die Metallisierung 51 der Emitter 31 des Darlingtontransistors angeschlossen wird. Unterhalb der Metallisierung 50 ist noch eine starke P+ Dotierung vorgesehen, um einen ohmschen Kontakt zum Basisbereich 20 sicherzustellen. Unterhalb der Metallisierung 51 ist noch eine starke N+ Dotierung vorgesehen, um den Emitter 31 mit einem ohmschen Kontakt zu kontaktieren. Die entsprechenden Kontaktierungen sind hier aus Gründen der Einfachheit in den Figuren 4 und 5 nicht dargestellt worden. Durch die Metallisierung 3a wird der Emitter 30 (vergleiche Figur 5) des Darlingtontreibertransistors mit der Basis 3 (vergleiche Figur 4) des Darlingtontransistors verbunden. Auf die Darstellung der entsprechenden Kontaktierungen wurde aus Einfachheitsgründen wieder verzichtet.

Durch eine Zusammenschau mit der Figur 5 erkennt man, daß durch die Metallisierung 53 und die Kontakte 60 die Anode 32 der Zenerdiode Z1a mit der starken Endotierung 4 verbunden wird. Durch den Streifen 54 wird dann die Anode 33 der Zenerdiode Z1a mit der Kathode der Zenerdiode Z1b verbunden. Entsprechendes gilt für den Metallstreifen 55. Durch den Metallstreifen 56 wird die Anode der Zenerdiode Z1c mit der in der Figur 4 gezeigten Wanne 21 und somit mit dem Widerstand R1 verbunden. Durch den Kontakt 61 wird der Widerstand R1 mit der rahmenförmigen Deckelelektrode 6 verbunden. Durch den Kontakt 61 wird somit der Abgriff des Spannungsteilers geschaffen. Durch die Kontakte 62 und die Metallisierung 57 wird die Kathode 32 (vergleiche Figur 5) der Zenerdiode Z2a mit der Metallisierung 6 bzw. die Anode 33 (vergleiche Figur 5) mit der P-Wanne 22 (vergleiche Figur 4) und somit mit dem Widerstand R2 verbunden. Der Widerstand R2 ist an seinem anderen Ende durch den Kontakt 63 mit der Metallisierung 9 des Hilfstransistors TR verbunden. Die Metallisierung 9 ist dann durch die Kontakte 64 mit dem Widerstand RT1 und der Emitterzone 8 des Hilfstransistors TR verbunden (vergleiche Figur 5). Die Basis 7 des Hilfstransistors ist dann über die Metallisierung 10 und die entsprechenden Kontakte mit dem Widerstand RT1 und dem Widerstand RT2 verbunden (vergleiche Figur 5). Der Widerstand RT2 ist dann über das Kontaktloch 65 mit dem Metall 3a verbunden. Durch dieses Metall 3a wird auch ein ohmscher Kontakt zur π-Dotierungszone 3 hergestellt. Sofern die Kontaktlöcher 60 bis 65 unmittelbar mit schwach dotierten Zonen in Kontakt stehen, sind noch entsprechende starke Aufdotierungen zur Herstellung eines ohmschen Kontakts vorgesehen. Diese starken Aufdotierungen sind in den Figuren aus Einfachheitsgründen nicht dargestellt.

Da ein Teil der am Spannungsteiler anliegenden Spannung über die Zenerdioden Z1, Z2 und den Transistor TR abfällt, können die Widerstände R1 und R2 vergleichsweise klein ausgelegt werden. Insgesamt wird durch die Verwendung der Zenerdioden der Gesamtbedarf des Spannungsteilers gegenüber dem Spannungsteiler nach der Ep 99 897 deutlich verringert. Durch den Hilfstransistor läßt sich eine weitgehende Temperaturkompensation des Spannungsteilers erreichen. Für den Hilfstransistor TR werden nur Dotierungszonen verwendet, die für die hier gezeigten Darlingtontransistoren sowieso verwendet werden müssen. Es sind somit keine zusätzlichen Herstellungsschritte für den Hilfstransistor erforderlich.

In den Figuren 1 bis 6 wurde jeweils von einem N-Substrat und einer darin eingebrachten π-Zone 3 ausgegangen. Dem Fachmann ist jedoch selbstverständlich, daß die entsprechenden Dotierungszonen jeweils durch die entgegengesetzte Dotierung ersetzt werden können. Als Ausführungsbeispiel wurde hier ein Darlingtontransistor gezeigt. Die Erfindung ist jedoch bei beliebigen Bauelementen einsetzbar, bei denen die Durchbruchspannung eines PN-Übergangs gegen das Substrat eingestellt werden soll. Weiterhin wurde im vorliegenden Beispiel ein PNP-Hilfstransistor verwendet, der ebensogut durch einen NPN-Transistor ersetzt werden kann.

**Patentansprüche**

1. Monolithisch integrierte planare Halbleiteranordnung mit wenigstens einem PN-Übergang, der durch das einen ersten Leitfähigkeitstyp aufweisende Substrat (1, 2) und eine in das Substrat (1, 2) eingebrachte Zone (3) eines zweiten, entgegengesetzten Leitfähigkeitstyps gebildet ist, mit einer über einer Passivierungsschicht (5) angeordneten Deckelektrode (6), die die im Sperrbetrieb auftretende Raumladungszone des PN-Übergangs überdeckt und mit einem Spannungsteiler, der dem PN-Übergang parallel geschaltet und dessen Abgriff mit der Deckelektrode (6) verbunden ist, wobei der Spannungsteiler in die Halbleiteranordnung integriert ist und Elemente mit positivem Temperaturkoeffizienten aufweist, dadurch gekennzeichnet, daß der Spannungsteiler weitere Elemente mit negativem Temperaturkoeffizienten aufweist.

2. Halbleiteranordnung nach Anspruch 1, dadurch gekennzeichnet, daß für die Elemente mit positivem Temperaturkoeffizienten Zenerdioden (Z1, Z2) vorgesehen sind.

3. Halbleiteranordnung nach Anspruch 1 oder Anspruch 2, dadurch gekennzeichnet, daß für die Elemente mit positivem Temperaturkoeffizienten Widerstände (R1, R2) in das Halbleiterelement integriert werden.

4. Halbleiterelement nach einem der vorhergehenden Ansprüche, dadurch gekennzeichnet, daß für die weiteren Elemente mit negativem Temperaturkoeffizienten ein Transistor (TR) mit einer Basis, einem Emitter und einem Kollektor, insbesondere ein Bipolartransistor, mit in die Halbleiteranordnung integriert wird, wobei zwischen der Basis und dem Emitter und der Basis und dem Kollektor jeweils ein Widerstand RT1, RT2 angeordnet wird.

5. Halbleiteranordnung nach Anspruch 4, dadurch gekennzeichnet, daß der Transistor (TR) in die eingebrachte Zone des zweiten Leitungstyps integriert ist.

6. Halbleiterelement nach Anspruch 5, dadurch gekennzeichnet, daß die eingebrachte Zone (3) des ersten Leitfähigkeitstyps den Kollektor des Transistors (TR) bildet.

7. Halbleiterelement nach einem der vorhergehenden Ansprüche, dadurch gekennzeichnet, daß unterhalb der Deckelektrode (6) im Bereich der Raumladungszone eine stark dotierte Zone (4) des ersten Leitfähigkeitstyps angeordnet ist.

**Claims**

1. Monolithically integrated planar semiconductor arrangement having at least one PN junction formed by the substrate (1, 2), which has a first conductivity type, and a zone (3) of a second, opposite conductivity type, which zone is introduced into the substrate (1, 2), having a covering electrode (6), which is arranged above a passivation layer (5) and covers the space charge zone of the PN junction that occurs in the off-state mode, and having a voltage divider which is connected in parallel with the PN junction and whose tap is connected to the covering electrode (6), the voltage divider being integrated in the semiconductor arrangement and having elements with a positive temperature coefficient, characterized in that the voltage divider has further elements with a negative temperature coefficient.

2. Semiconductor arrangement according to Claim 1, characterized in that zener diodes (Z1, Z2) are provided for the elements with a positive temperature coefficient.

3. Semiconductor arrangement according to Claim 1 or Claim 2, characterized in that, for the elements with a positive temperature coefficient, resistors (R1, R2) are integrated in the semiconductor element.

4. Semiconductor element according to one of the preceding claims, characterized in that for the further elements with a negative temperature coefficient, a transistor (TR) having a base, an emitter and a collector, in particular a bipolar transistor, is concomitantly integrated in the semiconductor arrangement, a respective resistor RT1, RT2 being arranged between the base and the emitter and between the base and the collector.

5. Semiconductor arrangement according to Claim 4, characterized in that the transistor (TR) is integrated into the introduced zone of the second conduction type.

6. Semiconductor element according to Claim 5, characterized in that the introduced zone (3) of the first conductivity type forms the collector of the transistor (TR).

7. Semiconductor element according to one of the preceding claims, characterized in that a heavily doped zone (4) of the first conductivity type is arranged underneath the covering electrode (6) in the region of the space charge zone.

**Revendications**

1. Dispositif semi-conducteur planar monolithique intégré comportant au moins une jonction PN, formé par

   - un substrat (1, 2) d'un type de conductibilité et une zone (3) introduite dans le substrat (1, 2) et correspondant à un second type de conductibilité, opposé,
   - une électrode de recouvrement (6) au-dessus d'une couche de passivation (5), cette électrode recouvrant la zone de charge d'espace de la jonction PN qui se produit en mode bloqué, et
   - un diviseur de tension en parallèle sur la jonction PN et dont la prise est reliée à l'électrode de recouvrement (6),
   - le diviseur de tension étant intégré dans le dispositif semi-conducteur et comportant des éléments ayant un coefficient de température positif,

   caractérisé en ce que
   le diviseur de tension comporte d'autres éléments à coefficient de température négatif.

2. Dispositif semi-conducteur selon la revendication 1,
   caractérisé en ce que
   les éléments à coefficient de température positif sont des diodes Zener (Z1, Z2).

3. Dispositif semi-conducteur selon la revendication 1 ou la revendication 2,
   caractérisé en ce que
   les éléments à coefficient de température positif sont des résistances (R1, R2) intégrées dans l'élément semi-conducteur.

4. Dispositif semi-conducteur selon l'une des revendications précédentes,
   caractérisé en ce que
   pour les autres éléments à coefficient de température négatif, on intègre un transistor (TR) avec une base, un émetteur et un collecteur, notamment un transistor bipolaire, dans le dispositif semi-conducteur, tandis qu'entre la base et l'émetteur et entre la base et le collecteur, on met chaque fois une résistance RT1, RT2.

5. Dispositif semi-conducteur selon la revendication 4,
   caractérisé en ce que
   le transistor (TR) est intégré dans la zone introduite correspondant au second type de conductibilité.

6. Dispositif semi-conducteur selon la revendication 5,
caractérisé en ce que
la zone (3) introduite, correspondant au premier type de conductibilité, est le collecteur du transistor (TR).

7. Dispositif semi-conducteur selon l'une des revendications précédentes,
caractérisé en ce qu'
en dessous de l'électrode de recouvrement (6), au niveau de la zone de charge d'espace, on a une zone à fort dopage (4) du premier type de conductibilité.

# Fig. 1

# Fig. 2

# Fig. 3

# Fig. 4

# Fig. 5

# Fig. 6